# EUROPEAN PATENT APPLICATION

(11) **EP 4 369 392 A1**
(43) Date of publication of application: **15.05.2024**
(21) Application number: 23191631.3
(22) Date of filing: 16.08.2023
(51) Int. Cl.: H01L 23/48, H01L 23/00, H01L 25/065

(54) **SEMICONDUCTOR PACKAGE**

(30) Priority: 09.11.2022 KR 20220148407
(71) Applicant: Samsung Electronics Co., Ltd., Suwon-si, Gyeonggi-do 16677 (KR)
(72) Inventor: KIM, Hyeonjeong, 16677 Suwon-si, Gyeonggi-do (KR); LEE, Jongmin, 16677 Suwon-si, Gyeonggi-do (KR); CHOI, Jimin, 16677 Suwon-si, Gyeonggi-do (KR)
(74) Representative: Kuhnen & Wacker Patent- und Rechtsanwaltsbüro PartG mbB

(57) **Abstract**

A semiconductor package includes a first semiconductor chip including a circuit layer on a first substrate, first through silicon vias passing through the first substrate, first lower bump pads on the circuit layer, and a first upper bump pad and a second upper bump pad on a second surface of the first substrate, each of the first upper bump pad and the second upper bump pad connected to a corresponding one of the first through silicon vias. The package includes a second semiconductor chip including a circuit layer on a first surface of a second substrate, and second lower bump pads on the circuit layer on the second substrate. The package includes a first solder bump to bond the first upper bump pad and the second lower bump pad, and a plurality of second solder bumps to bond the second upper bump pad and the second lower bump pads.

## Description

### CROSS-REFERENCE TO RELATED APPLICATION

This application claims priority under 35 USC § 119 to Korean Patent Application No. 10-2022-0148407, filed on November 9, 2022, in the Korean Intellectual Property Office (KIPO), the contents of which are incorporated by reference herein in their entirety.

### FIELD

Some example embodiments relate to a semiconductor package, including a semiconductor package in which a plurality of semiconductor chips is stacked.

### BACKGROUND

Recently, a semiconductor package may have a structure in which a plurality of stacked semiconductor chips is packaged. As the semiconductor package is desired or required to store high-capacity data, the number of semiconductor chips stacked in the semiconductor package may increase. Accordingly, a thermal resistance in the semiconductor package may be increased.

### SUMMARY

Some example embodiments provide a semiconductor package with reduced thermal resistance.

According to some example embodiments, a semiconductor package includes a first semiconductor chip including a circuit layer on a first surface of a first substrate, first through silicon vias passing through the first substrate, first lower bump pads on the circuit layer on the first substrate, each of the first lower bump pads connected to a corresponding one of the first through silicon vias, and a first upper bump pad and a second upper bump pad on a second surface of the first substrate, the second surface opposite to the first surface of the first substrate, each of the first upper bump pad and the second upper bump pad connected to a corresponding one of the first through silicon vias. The package includes a second semiconductor chip including a circuit layer on a first surface of a second substrate, and second lower bump pads on the circuit layer on the second substrate. The package includes a first solder bump between the first upper bump pad and the second lower bump pad to bond the first upper bump pad and the second lower bump pad, and a plurality of second solder bumps between the second upper bump pad and the second lower bump pads to bond the second upper bump pad and the second lower bump pads, wherein the plurality of second solder bumps are spaced apart from each other on the second upper bump pad.

According to some example embodiments, a semiconductor package includes a buffer die, a plurality of first semiconductor chips sequentially stacked on the buffer die, and a sealing member covering the first semiconductor chips on the buffer die. Each of the first semiconductor chips includes a circuit layer on a first surface of a first substrate, first through silicon vias passing through the first substrate, lower bump pads on the circuit layer on the first substrate, each of the lower bump pads connected to a corresponding one of the first through silicon vias, a first bump pad and a second bump pad on a second surface of the first substrate, the second surface opposite to the first surface of the first substrate, wherein an upper surface area of the second bump pad is greater than an upper surface area of the first bump pad, and a first solder bump between the first bump pad and one of the lower bump pads of one of the plurality of first semiconductor chips above the second surface. The package includes a plurality of second solder bumps between the second bump pad and lower bump pads of the one of the plurality of first semiconductor chips above the second surface.

According to some example embodiments, a semiconductor package includes a first semiconductor chip including lower bump pads on a first surface of a first substrate, and a first upper bump pad and a second upper bump pad on a second surface of the first substrate, the second surface opposite to the first surface of the first substrate, wherein an upper surface area of the second upper bump pad is greater than an upper surface area of the first upper bump pad. The package includes solder bumps on each of the first upper bump pad and second upper bump pad, and a second semiconductor chip bonded on the first semiconductor chip by the solder bumps, wherein one of the solder bumps is on the first upper bump pad, and a plurality of the solder bumps are on the second upper bump pad.

In some example embodiments, the semiconductor package may include semiconductor chips, and each of the semiconductor chips may include first bump pads and second bump pad having an upper surface area greater than an upper surface area of each of the first bump pads. A plurality of second solder bumps may be formed on the second bump pad, and the upper semiconductor chip may be bonded on the semiconductor chip by the second solder bumps. Some of the second solder bumps may serve as a thermal path bump. Accordingly, a thermal resistance in the semiconductor package may be decreased.

### BRIEF DESCRIPTION OF THE DRAWINGS

Some example embodiments will be more clearly understood from the following detailed description taken in conjunction with the accompanying drawings.
FIG. 1 is a cross-sectional view of a semiconductor package according to an example embodiment.
FIG. 2 is a cross-sectional view illustrating a portion of a semiconductor chip in a semiconductor package according to an example embodiment.
FIG. 3A is a plan view illustrating an example embodiment of arrangements of first bump pads, second bump pads, and first and second solder bumps in the semiconductor package.
FIG. 3B is a plan view illustrating another example embodiment of arrangements of first bump pads, second bump pads, and first and second solder bumps in the semiconductor package.
FIG. 3C is a plan view illustrating another example embodiment of arrangements of first bump pads, second bump pads, and first and second solder bumps in the semiconductor package.
FIG. 4 is an example embodiment of a vertical cross-sectional view of first and second bump pads in the semiconductor package.
FIGS. 5 to 14 are cross-sectional views illustrating a method of manufacturing a semiconductor package according to an example embodiments.

### DETAILED DESCRIPTION

Hereinafter, some example embodiments of the inventive concepts will be described in detail with reference to the accompanying drawings. Hereinafter, two directions parallel to and perpendicular to a surface of a substrate are referred to as a first direction and a second direction, respectively, and a direction perpendicular to the surface of the substrate is referred to as a vertical direction.

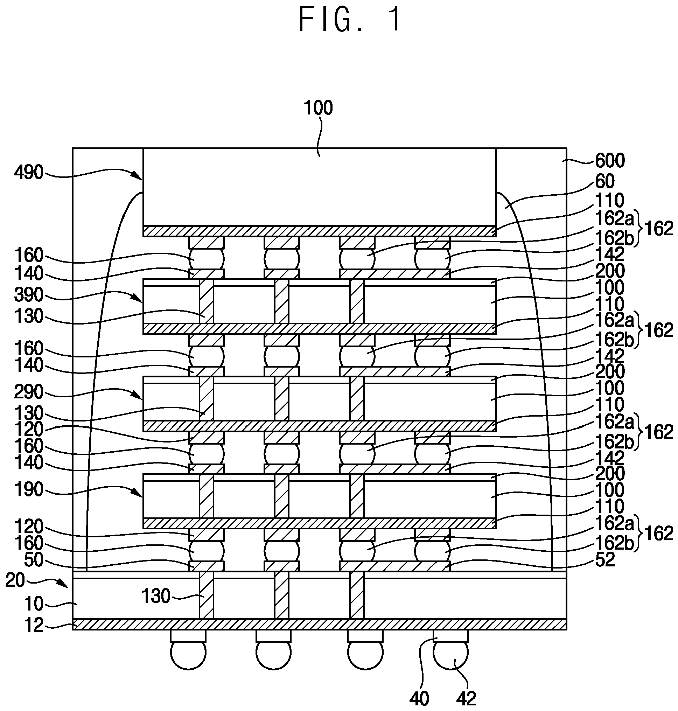

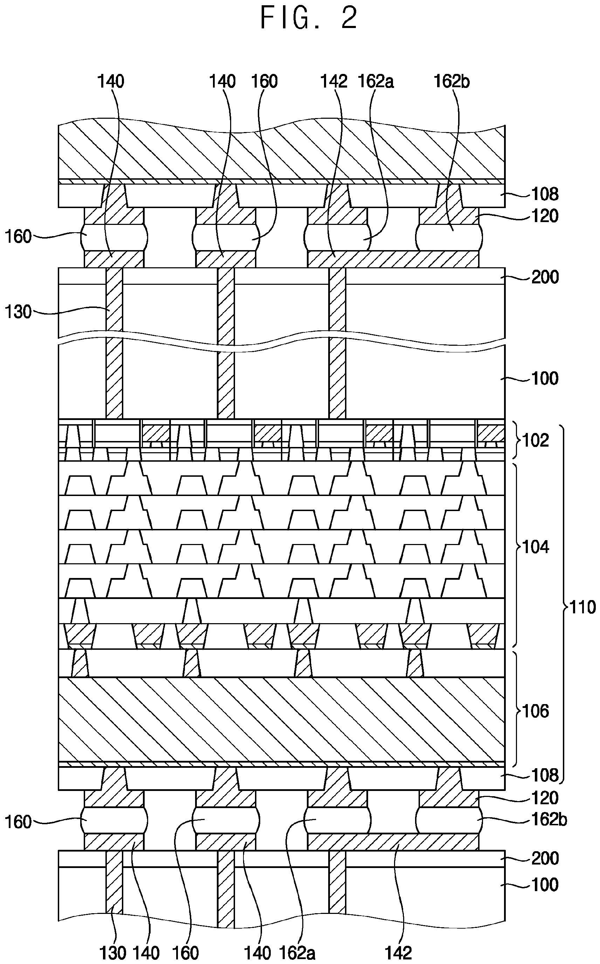

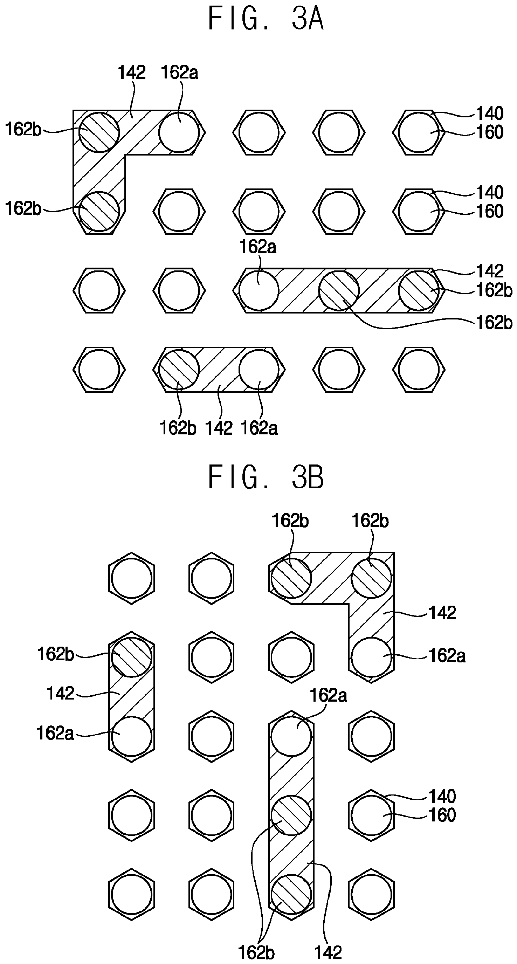

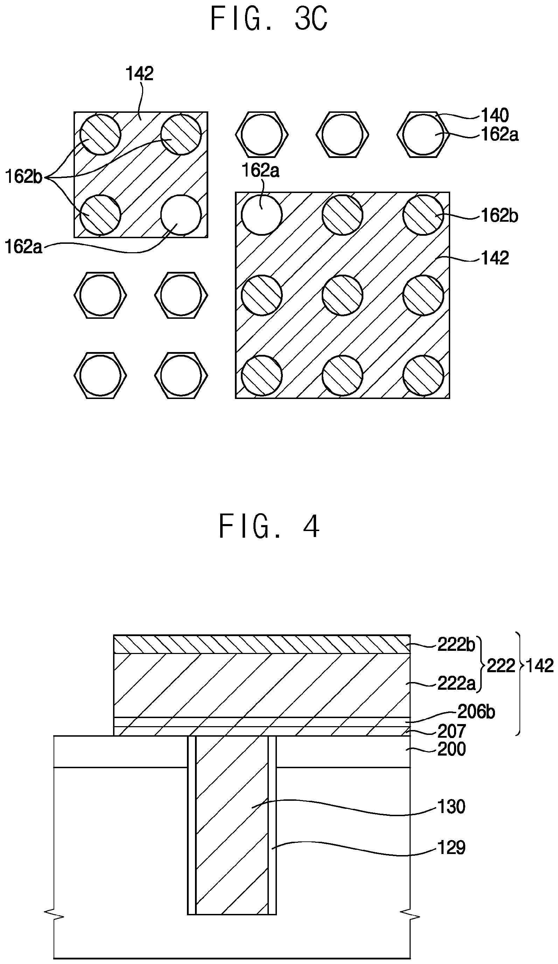

FIG. 1 is a cross-sectional view of a semiconductor package according to some example embodiments. FIG. 2 is a cross-sectional view illustrating a portion of a semiconductor chip in a semiconductor package according to some example embodiments. FIG. 3A is a plan view illustrating an example embodiment of arrangements of first bump pads, second bump pads, and first and second solder bumps in the semiconductor package. FIG. 3B is a plan view illustrating another example embodiment of arrangements of first bump pads, second bump pads, and first and second solder bumps in the semiconductor package. FIG. 3C is a plan view illustrating another example embodiment of arrangements of first bump pads, second bump pads, and first and second solder bumps in the semiconductor package. FIG. 4 is an example embodiment of a vertical cross-sectional view of first and second bump pads in the semiconductor package.

The semiconductor package may be a high-bandwidth memory.

Referring to FIG. 1, the high-bandwidth memory may include a buffer die 20 including a lower control circuit and a plurality of semiconductor chips 190, 290, 390 and 490 sequentially stacked on the buffer die 20. An adhesive material 60 may be interposed between the buffer die 20 and the semiconductor chip 190, and between the semiconductor chips 190, 290, 390 and 490. In some example embodiments, the adhesive material 60 may cover sidewalls of the buffer die 20 and the semiconductor chips 190, 290, 390 and 490. A sealing member 600 may be formed on a stacked structure including the buffer die 20 and the semiconductor chips 190, 290, 390 and 490. In some example embodiments, the sealing member 600 may be formed on the adhesive material 60. The semiconductor chips 190, 290, 390, and 490 may be memory chips. For example, the semiconductor chips 190, 290, 390, and 490 may be DRAM chips. Sequentially stacked semiconductor chips on the buffer die 20 are referred to as first to fourth semiconductor chips in order.

Through silicon vias (TSVs) 130 may be included in the buffer die 20 and the semiconductor chips 190, 290, 390 and 490. Through silicon vias (TSVs) 130 may pass through the buffer die 20 and the semiconductor chips 190, 290, 390 and 490, respectively. The through silicon vias 130 may be bonded to each other using bump pads 50, 52, 120, 140 and 142 and solder bumps 160 and 162. Therefore, the plurality of semiconductor chips 190, 290, 390 and 490 may be bonded to each other, and may be stacked in the vertical direction.

The bump pads 50, 52, 120, 140 and 142 may include a lower bump pad 120, first bump pads 50 and 140 and second bump pads 52 and 142, according to positions thereof.

A plurality of lower bump pads 120 may be disposed on a first surface of substrate 100 included in each of the semiconductor chips 190, 290, 390 and 490. The first and second bump pads 50, 52, 140 and 142 may be disposed on a second surface opposite to the first surface of the substrate 10 or 100 included in each of the semiconductor chips 190, 290, 390 and 490 and buffer die 20. The first bump pads 50 and 140 may serve as a signal transmission pad, and the second bump pads 52 and 142 may serve as the signal transmission pad and a thermal path pad for reducing thermal resistance. Each of the second bump pads 52 and 142 may have an upper surface area greater than an upper surface area of each of the first bump pads 50 and 140.

The solder bumps may include first solder bumps 160 and second solder bumps 162. The first solder bump 160 may be interposed between the first bump pads 50 and 140, and the lower bump pad 120 of an upper semiconductor chip (e.g., a semiconductor chip stacked on the first bump pad). The second solder bumps 162 may be interposed between the second bump pads 52 and 142, and the lower bump pads 120 of the upper semiconductor chip. At least two second solder bumps 162 may be disposed on each of the second bump pads 52 and 142. The second solder bumps 162 on each of the second bump pads 52 and 142 may be spaced apart from each other.

Hereinafter, a first semiconductor chip and a bump structure connected to the first semiconductor chip may be described with reference to FIG. 2 together.

Referring to FIGS. 1 and 2, the first semiconductor chip 190 may include a circuit layer 110 formed on the first surface of a first substrate 100. The circuit layer 110 may include a memory cell layer 102, multilayer wirings 104 electrically connected to the memory cell layer 102, an uppermost wiring 106 and a passivation layer 108, etc. In some example embodiments, the memory cell layer 102 may include cell transistors, bit line structures, lower wiring and capacitors, but example embodiments are not limited thereto.

The uppermost wiring 106 may be simply shown as one pattern, but may include a plurality of patterns according to circuit design. For example, the patterns included in the uppermost wiring 106 may be spaced apart from each other, and each of the patterns may be electrically connected to one of the lower bump pads 120. The passivation layer 108 may cover uppermost wirings 106. The passivation layer 108 may be formed of an insulation material. In some example embodiments, the passivation layer 108 may include silicon oxide or silicon nitride. The passivation layer 108 may have a structure in which silicon oxide and silicon nitride are stacked.

Each of the lower bump pads 120 may be disposed on the passivation layer 108 while passing through the passivation layer 108 and contacting the uppermost wiring 106. Each of the lower bump pads 120 may include a metal material, e.g., copper, tin (Sn), nickel (Ni), gold (Au), silver (Ag), etc. These may be used alone or stacked two or more.

Each of the semiconductor chips may be disposed so that the first surface of the substrate 100 on which the circuit layer 110 is formed faces downward.

The through silicon vias 130 may pass through the first substrate 100. The through silicon vias 130 may extend from the first surface of the first substrate 100 to the second surface of the first substrate 100 in the vertical direction. An insulation layer 200 may be formed on the second surface of the first substrate 100. The through silicon via 130 may further pass through the insulation layer 200.

In some example embodiments, the through silicon via 130 may be formed inside a via hole penetrating the first substrate 100. The through silicon via 130 may include a metal pattern and an insulation liner 129 surrounding sidewalls of the metal pattern. The metal pattern may include, e.g., copper. In some example embodiments, a barrier metal layer may be included between the insulation liner and the metal pattern.

Bump regions for forming solder bumps may be defined on the insulation layer 200 of the first substrate 100. The lower bump pad 120 of an upper semiconductor chip (e.g., a second semiconductor chip) may be disposed on the solder bump in the bump region. Accordingly, the bump region may face the lower bump pad 120 in the vertical direction. The bump regions may be regularly arranged to be spaced apart from each other in each of the first and second directions. The bump region may include a first bump region for forming a solder bump directly connected to the through silicon via 130 in the vertical direction and a second bump region for forming a solder bump not directly connected to the through silicon via 130 in the vertical direction. The first bump region may be aligned to the through silicon via 130 in the vertical direction, and the second bump region may not be aligned to the through silicon via 130 in the vertical direction.

The bump regions may be arranged at designed positions for electrical connections of the stacked semiconductor chips, respectively.

Each of the through silicon vias 130 may be disposed in the first bump region. The through silicon via 130 may not be disposed in the second bump region.

In some example embodiments, one bump pad may be formed on each of the through silicon vias 130. A first bump pad 140 or a second bump pad 142 may be formed on each of the through silicon vias 130. The first and second bump pads 140 and 142 may be positioned on the second surface of the first substrate 100.

The first bump pad 140 may cover one through silicon via 130. One first solder bump 160 may be bonded on the first bump pad 140. Accordingly, the first bump pad 140 may have a first upper surface area on which one first solder bump 160 may be formed.

The second bump pad 142 may cover one through silicon via 130, and the second bump pad 142 may have a second upper surface area greater than the first upper surface area of the first bump pad 140. At least two second solder bumps 162 being spaced apart from each other may be formed on the second bump pad 142. Accordingly, the second bump pad 142 may have the second upper surface area on which at least two second solder bumps 162 may be formed.

The first solder bump 160 or the second solder bump 162 may be formed on a surface (e.g., a bottom surface) of the lower bump pad 120. Each of the first and second solder bumps 160 and 162 may be matched 1:1 with one lower bump pad 120.

The first solder bumps 160 may be aligned to the through silicon vias 130 in the vertical direction. Accordingly, the first solder bump 160 may serve as the signal transmission bump.

The second solder bump 162 may include a solder bump aligned to the through silicon vias 130 in the vertical direction and a solder bump not aligned to the through silicon vias 130 in the vertical direction.

The second solder bump 162 may include a signal transmission bump 162a and a thermal path bump 162b.

For example, the second solder bumps 162 aligned to the through silicon vias 130 in the vertical direction may serve as signal transmission bumps 162a. One of the second sold bumps 162 formed on the second bump pad 142 may serve as the signal transmission bump. That is, one of the second sold bumps formed on the second bump pad 142 may be aligned to the through silicon vias 130. The second solder bumps 162 not aligned to the through silicon vias 130 may serve as the thermal path bumps 162b.

Various examples of shapes and areas of the second bump pad 142 may be illustrated.

In some example embodiments, in a plan view, the second bump pad 142 may have a line shape extending in one direction. Each of the second bump pads 142 may cover one of through silicon vias 130 and at least one of the second bump region adjacent the one of through silicon vias 130.

For example, as shown in FIG. 3A, each of the second bump pads 142 may cover one of the through silicon vias 130 and at least one second bump region neighboring the one of the through silicon vias 130 in the first direction. At least some of the second bump pads 142 may extend in the first direction while contacting lower surfaces of the second solder bumps 162 being spaced apart from each other in the first direction.

Some of the second bump pads 142 may cover one of the through silicon vias 130, with second bump regions neighboring the one of the through silicon vias 130 in each of the first and second directions. Some of the second bump pads 142 may have a bent line shape to cover the neighboring second bump regions in each of the first and second directions. Some of the second bump pads 142 may have the bent shape while contacting lower surfaces of the second solder bumps 162 being spaced apart from each other in each of the first and second directions.

For example, as shown in FIG. 3B, each of the second bump pads 142 may extend to cover one of through silicon vias 130 and at least one second bump region neighboring the one of through silicon vias 130 in the second direction. The second bump pad 142 may extend in the second direction while contacting lower portions of the second solder bumps 162 being spaced apart in the second direction.

In some example embodiments, in a plan view, as shown in FIG. 3C, each of the second bump pads 142 may have a rectangular shape covering one of through silicon vias 130, at least one of the second bump regions adjacent to the one of the through silicon vias 130 in the first direction and at least one of the second bump region adjacent to the one of the through silicon vias 130 in the second direction. An upper surface of the second bump pad 142 may have a rectangular shape while contacting lower portions of the second solder bumps 162 being spaced apart from each other in each of the first and second directions.

The first and second bump pads 140 and 142 may have the same or substantially the same stacked structure. The first and second bump pads 140 and 142 may include a metal material. For example, each of the first and second upper bump pads 140 and 142 may include at least one selected from copper, tin (Sn), nickel (Ni), gold (Au), and silver (Ag), but example embodiments are not limited thereto. These may be used singly or stacked two or more.

For example, as shown in FIG. 4, the first and second bump pads 140 and 142 may have a structure in which a seed copper pattern 206b, a nickel pattern 222a, and a gold pattern 222b are stacked. In some example embodiments, a barrier metal pattern 207 may be included under the seed copper pattern 206b. The barrier metal pattern 207 may include, e.g., titanium, titanium nitride, tantalum, tantalum nitride, or the like.

The semiconductor package may include the first semiconductor chip 190. The semiconductor package may further include the second to fourth semiconductor chips 290, 390 and 490, which may be sequentially bonded and stacked on the first semiconductor chip 190. Each of the second to fourth semiconductor chips 290, 390 and 490 may be a semiconductor device the same or substantially the same as a semiconductor device of the first semiconductor chip 190. Alternatively, at least one of the semiconductor chips 290, 390 and 490 may be a semiconductor device different from the semiconductor device of the first semiconductor chip 190. Each of the second to fourth semiconductor chips 290, 390 and 490 stacked on the first semiconductor chip 190 may have a bump structure the same or substantially the same as a bump structure of the first semiconductor chip 190.

Particularly, the first solder bumps 160 and the second solder bumps 162 disposed on the second semiconductor chip 290 may be bonded on the first bump pads 140 and the second bump pads 142 disposed on the first semiconductor chip 190.

That is, the first solder bump 160 may be formed between the first bump pad 140 on the first semiconductor chip 190 and the lower bump pad 120 on the second semiconductor chip 290, so that the first bump pad 140 and the lower bump pad 120 may be bonded to each other. A plurality of second solder bumps 162 may be formed between the second bump pad 142 on the first semiconductor chip 190 and the lower bump pad 120 on the second semiconductor chip, so that the second bump pad 142 and the lower bump pad 120 may be bonded to each other. Thus, the first and second semiconductor chips 190 and 290 may be bonded to each other.

One of the lower bump pads 120 may be aligned to one of the first bump pads 140 in the vertical direction.

A plurality of lower bump pads 120 may be disposed on the second bump pads 142. One of the lower bump pads 120 disposed on the second bump pad 142 may be aligned with the through silicon via 130 in the first semiconductor chip 190 in the vertical direction. At least some of the lower bump pads 120 disposed on the second bump pad 142 may not be aligned with the through silicon via 130 in the first semiconductor chip 190 in the vertical direction.

In the same manner, the third and fourth semiconductor chips 390 and 490 may be sequentially bonded on the second semiconductor chip 290.

As such, the second solder bumps 162 disposed on the second bump pad 142 may include one signal transmission bump 162a and at least one thermal path bump 162b.

In some example embodiments, the second semiconductor chip 290 may include the circuit layer 110 formed on the first surface of the first substrate. Lower bump pads 120 may be formed on the circuit layer 110.

The first solder bump 160 may be interposed between the first bump pad 140 on the first semiconductor chip 190 and the lower bump pad 120 on the second semiconductor chip 290, and thus the first bump pad 140 and the lower bump pad 120 may be electrically connected to each other by the first solder bump 160. Accordingly, the first solder bump 160 may serve as a signal transmission bump for electrically connecting between the first and second semiconductor chips 190 and 290.

Some of the second solder bumps 162 on the second bump pad 142 may be disposed to face the through silicon via 130, and may serve as signal transmission bumps 162a. Some of the second solder bumps 162 on the second bump pad 142 may be disposed not to face the through silicon via 130, and thus the second solder bump 162 may not be used as the signal transmission and may serve as a thermal path bump 162b for reducing thermal resistance. Heat generated in the semiconductor package may be rapidly conducted through the thermal path bump 162b and the through silicon via 130, and thus a thermal resistance generated in the semiconductor package may be decreased. That is, the thermal path bump 162b and the through silicon via 130 may be connected to each other in the vertical direction, so that a vertical thermal resistance of the semiconductor package may be decreased.

Also, as the upper surface area of the second bump pad 142 increases, an area of the metal material having high thermal conductivity may increase. Accordingly, the heat generated in the semiconductor package may be rapidly conducted through the second bump pads 142, and thus a horizontal thermal resistance of the semiconductor package may be decreased.

As described above, the semiconductor chips may be electrically connected to each other through the bump pads and solder bumps, and may be vertically stacked. In FIG. 1, the semiconductor chips may be stacked in four layers on the buffer die, but the number of the stacked semiconductor chips may not be limited thereto. For example, the semiconductor chip may be stacked in ten or more layers. The number of the stacked semiconductor chips included in the high-bandwidth memory may increase, and thus the thermal resistance generated due to the bump pads and solder bumps may increase.

In some example embodiments, the semiconductor package may include the second bump pad having the upper surface area greater than the upper surface area of the first bump pad, and may include the plurality of second solder bumps on the second bump pad. Therefore, the horizontal thermal resistance and the vertical thermal resistance may be decreased.

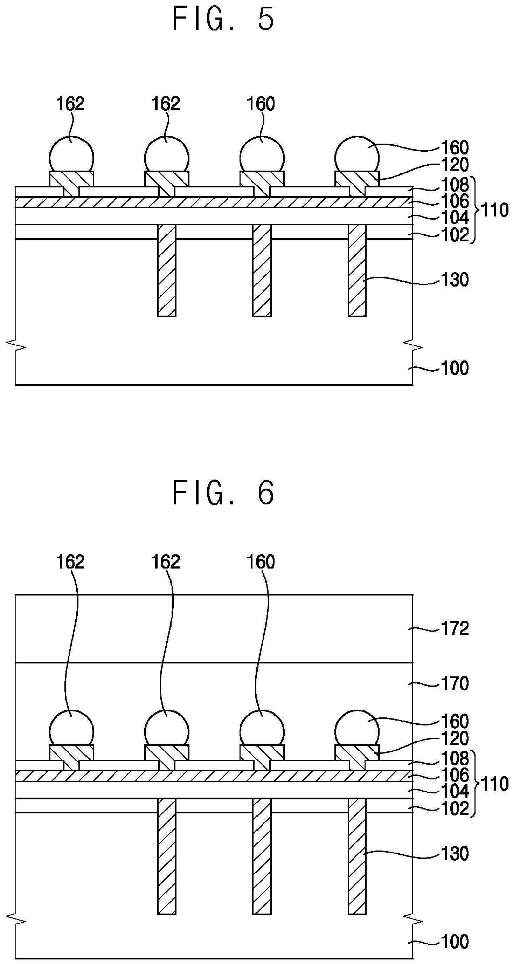

FIGS. 5 to 14 are cross-sectional views illustrating a method of manufacturing a semiconductor package according to some example embodiments.

First, a method for forming a first semiconductor chip may be described.

Referring to FIG. 5, a memory cell layer 102 including a memory cell structure and a lower insulating interlayer may be formed on a first surface of a first substrate 100.

The memory cell layer 102 and an upper portion of the first substrate 100 may be etched to form a plurality of through silicon via holes passing through the memory cell layer 102 and the upper portion of the first substrate 100. An insulation liner (not shown) may be formed on a sidewall and a bottom surface of each of the through silicon via holes. A metal pattern may be formed on the insulation liner to fill each of the through silicon via holes. Thus, a through silicon via 130 may be formed in each of the through silicon via hole.

Subsequently, a multilayer wiring 104 may be formed on the memory cell layer 102. In the multilayer wiring 104, a wiring including a via contact and a conductive line may be stacked in multiple layers. The multilayer wiring may be formed by a single damascene process or a dual damascene process. The via contacts and the conductive lines included in the multilayer wiring may include, e.g., copper.

An uppermost wiring 106 may be formed on the multilayer wiring 104. The uppermost wiring 106 may include an uppermost via connected to an uppermost multilayer wiring and an uppermost conductive pattern formed on the uppermost via. The uppermost via may include, e.g., tungsten, copper or aluminum. The uppermost conductive pattern may include, e.g., aluminum.

Subsequently, a passivation layer 108 may be formed to cover the uppermost wiring 106.

The passivation layer 108 of portions corresponding to bump regions may be etched to form openings. Lower bump pads 120 may be formed on the passivation layer 108 to fill the openings. In some example embodiments, the lower bump pad 120 may include a metal. In some example embodiments, the lower bump pads 120 may be regularly arranged in the first and second directions. The lower bump pads 120 may be formed on the bump regions, respectively.

The lower bump pads 120 may be disposed to face the through silicon vias 130, respectively. Further, the lower bump pads 120 may be disposed at portions where thermal path bumps are formed. Thus, some of the lower bump pads 120 may be disposed on portions that do not face the through silicon vias 130.

Solder bumps may be formed on each of the lower bump pads 120. The solder bumps may include a first solder bump 160 contacting the first bump pad and second solder bumps 162 contacting the second bump pad.

The first solder bump 160 may be disposed to face the through silicon via 130. Some of the second solder bumps 162 may be disposed to face the through silicon via 130, and some of the second solder bumps 162 may be disposed not to face the through silicon via 130.

Referring to FIG. 6, a bonding film 170 may be formed on a carrier substrate 172, and the first substrate 100 and the carrier substrate 172 may be bonded to etch other using the bonding film 170. Thus, the bonding film 170 may cover the lower bump pad 120 and the first and second solder bumps 160 and 162.

The carrier substrate 172 may include a silicon, germanium, silicon-germanium, gallium-arsenide (GaAs), glass, plastic, or ceramic, but example embodiments are not limited thereto. For example, the carrier substrate 172 may be a silicon substrate or a glass substrate. The bonding film 170 may include NCF (Non-Conductive Film), ACF (Anisotropic Conductive Film), UV film, instant adhesive, thermosetting adhesive, laser curable adhesive, ultrasonic curable adhesive, NCP (Non-Conductive Paste), or the like.

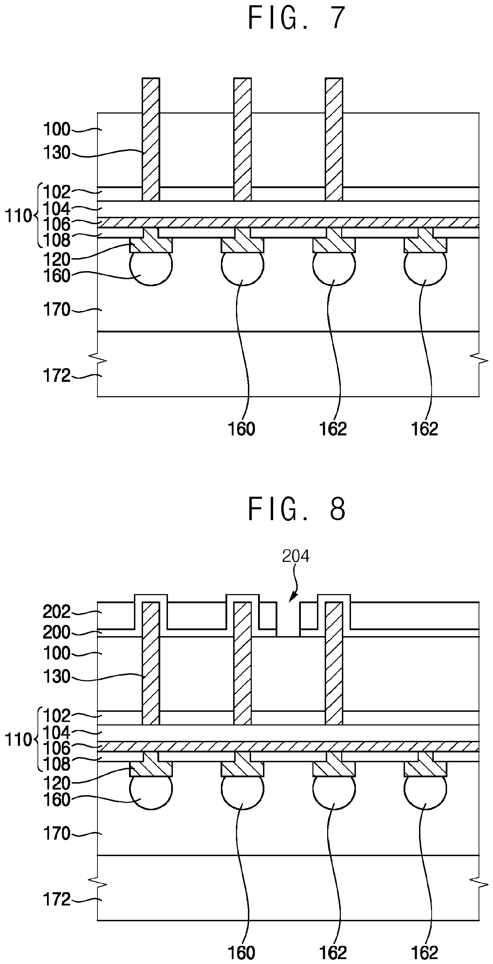

Referring to FIG. 7, the first substrate 100 may be rotated so that the first surface of the first substrate 100 may face downward. Therefore, a second surface opposite to the first surface of the first substrate 100 may be an upper side of the first substrate 100. That is, subsequent processes may be performed with the carrier substrate 172 positioned below.

The second surface of the first substrate 100 may be grinded to expose an upper surface of the through silicon via 130 on the second surface of the first substrate 100.

Thereafter, a portion of the second surface of the first substrate 100 may be additionally etched so that the through silicon via 130 may protrude from the second surface of the first substrate 100 by a partial thickness. A cleaning process of the second surface of the first substrate 100 may be performed.

Referring to FIG. 8, an insulation layer 200 may be conformally formed on the second surface of the first substrate 100 and a surface of the through silicon via 130. In some example embodiments, the insulation layer 200 may include a silicon oxide layer, a silicon nitride layer, and a silicon oxide layer sequentially stacked.

A photo process may be performed to form a first photoresist pattern 202 on the insulation layer 200, and the insulation layer 200 may be etched using the photoresist pattern 202 as an etching mask to form a first opening 204. The first opening 204 may serve as a photo key for alignment during subsequent photo processes.

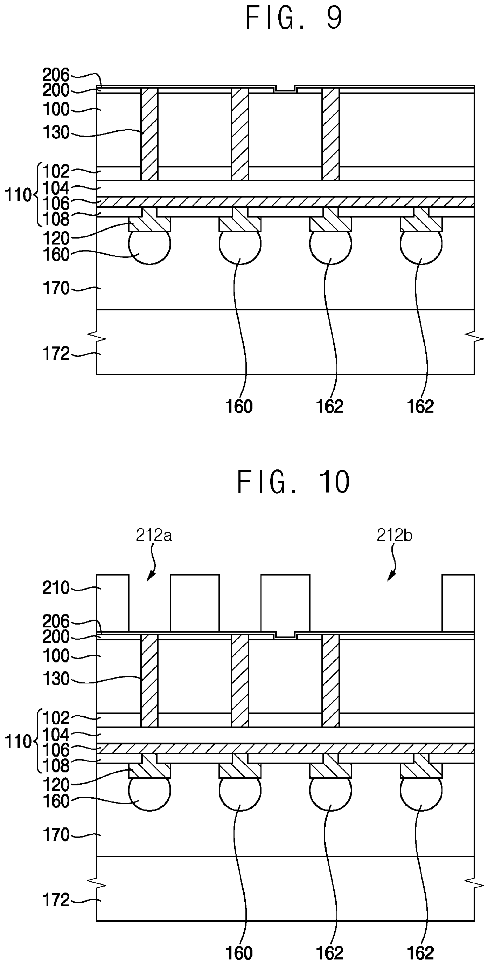

Referring to FIG. 9, the first photoresist pattern may be removed. Upper portions of the insulation layer 200 and the through silicon via 130 may be planarized by a chemical mechanical polishing process, so that protruding portions of the insulation layer 200 and the through silicon via 130 may be removed. Accordingly, surfaces (e.g., upper surfaces) of the insulation layer 200 and the through silicon vias 130 formed on the second surface of the first substrate 100 may be exposed. Further, the first substrate 100 may be exposed by the lower surface of the first opening 204.

A barrier metal layer may be formed on the insulation layer 200, through silicon via 130, and the first substrate 100 exposed by first opening 204. Subsequently, a seed metal layer 206 may be formed on the barrier metal layer. The seed metal layer 206 may include, e.g., copper.

Referring to FIG. 10, a photo process may be performed to form a second photoresist pattern 210 on the seed metal layer 206, and the second photoresist pattern 210 may selectively expose the seed metal layer 206 corresponding to a region for forming bump pads. The second photoresist pattern 210 may include second openings 212a for forming first bump pads and third openings 212b for forming second bump pads. The seed metal layer 206 may be exposed by bottom surfaces of the second and third openings 212a and 212b.

The bottom surface of each of the second openings 212a may be disposed to face one through silicon via 130 in the vertical direction. The bottom surface of each of the third openings 212b may be disposed to face one through silicon via 130 in the vertical direction. An area of the bottom of the third opening 212b may be larger than an area of the bottom of the second opening 212a.

A second pad metal pattern may be formed in the third opening 212b by subsequent processes. Therefore, an arrangement, a shape and a size of the third opening 212b may be changed to form desired second pad patterns, as shown in FIGS. 3A to 3C.

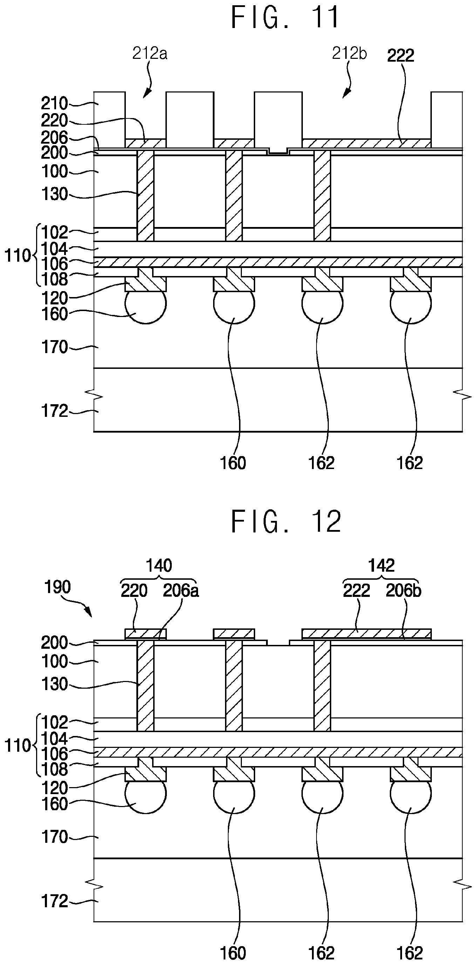

Referring to FIG. 11, pad metal patterns 220 and 222 may be formed on the seed metal layer 206 exposed by the bottom surfaces of the second and third openings 212a and 212b. The pad metal patterns 220 and 222 may be formed by an electroplating process.

A first pad metal pattern 220 may be formed on the bottom surface of the second opening 212a, and the second pad metal pattern 222 may be formed on the bottom surface of the third opening 212b. An upper surface area of the second pad metal pattern 222 may be greater than an upper surface area of the first pad metal pattern 220.

In some example embodiments, the first and second pad metal patterns 220 and 222 may include nickel, gold (Au), silver (Ag), or the like. For example, the first and second pad metal patterns 220 and 222 may have a structure in which a nickel pattern and a gold pattern are stacked.

Referring to FIG. 12, the second photoresist pattern 210 may be removed. Exposed seed metal layer 206 adjacent to both sides of each of the first and second pad metal patterns 220 and 222 may be removed. In addition, the barrier metal layer under the seed metal layer 206 may be removed. Accordingly, a barrier metal pattern and a first seed metal pattern 206a are formed under the first pad metal pattern 220, and a barrier metal pattern and a second seed metal pattern 206b may be formed under the second pad metal pattern 222. A first bump pad 140 in which the barrier metal pattern, the first seed metal pattern 206a and the first pad metal pattern 220 are stacked may be formed on the insulation layer 200, and a second bump pad 142 in which the pad metal pattern 222 is stacked may be formed on the insulation layer 200.

In some example embodiments, as shown in FIG. 4, each of the first and second bump pads 140 and 142 may include a barrier metal pattern 207, a seed copper pattern 206b, a nickel pattern 222a, and a gold pattern 222b stacked.

One first bump pad 140 may directly contact one through silicon via 130, and the first bump pad 140 may have a first upper surface area. One second bump pad 142 may directly contact one through silicon via 130, and the second bump pad 142 may have a second upper surface area greater than the first upper surface area.

Thereafter, a portion of the first substrate 100 may be cut to form individual first semiconductor chips 190. The first substrate 100 may be cut by a sawing process. Subsequently, the carrier substrate 172 may be removed.

The processes described with reference to FIGS. 5 to 12 may be performed to form each of multiple semiconductor chips included in a semiconductor package.

In some example embodiments, each of the second to fourth semiconductor chips 290, 390 and 490 may be a semiconductor device the same or substantially the as a semiconductor device of the first semiconductor chip 190. In some example embodiments, each of the second to fourth semiconductor chips 190, 290, 390 and 490 may be formed by performing the same or substantially the same process described with reference to FIGS. 5 to 12.

In some example embodiments, at least one of the second to fourth semiconductor chips 190, 290, 390 and 490 may be a semiconductor device different from a semiconductor device of the first semiconductor chip 190. In some example embodiments, the processes of forming the circuit layer 110 may be changed, and processes described with reference to FIGS. 5 to 12 may be performed in the same or substantially the same manner to form the semiconductor chip.

In some example embodiments, through silicon vias may not be formed in an uppermost semiconductor chip (e.g., a fourth semiconductor chip).

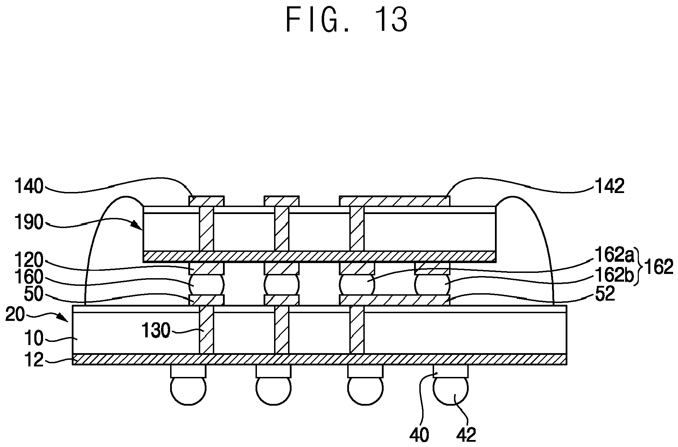

Referring to FIG. 13, a buffer die 20 may be formed on a base substrate 10. The buffer die 20 may include a circuit layer 12 including a lower control circuit on a first surface of the base substrate 10, and a through silicon via passing through the base substrate 10 and being electrically connected to the lower control circuit. In addition, lower bump pads 40 and lower solders 42 may be formed on the first surface of the base substrate 10. First and second bump pads 50 and 52 may be formed on the second surface of the base substrate 10.

The first semiconductor chip 190 may be attached to the buffer die 20. In some example embodiments, the first semiconductor chip 190 may be attached by a flip chip bonding process.

Particularly, the first surface of the first substrate 100 in the first semiconductor chip 190 may be disposed to face the buffer die 20. A thermal compression process may be performed at a predetermined temperature (e.g., about 400° C or less) to bond the first semiconductor chip 190 and the buffer die 20 on the base substrate 10. That is, the first solder bumps 160 of the first semiconductor chip 190 may be bonded to the first bump pads 50 of the buffer die 20, respectively. The second solder bumps 162 of the first semiconductor chip 190 may be bonded to the second bump pads 52 of the buffer die 20, respectively. An adhesive material 60 may be formed between the buffer die 20 and the first semiconductor chip 270 by the thermal compression process. For example, the adhesive material 60 may include a Non Conductive Film (NCF) material.

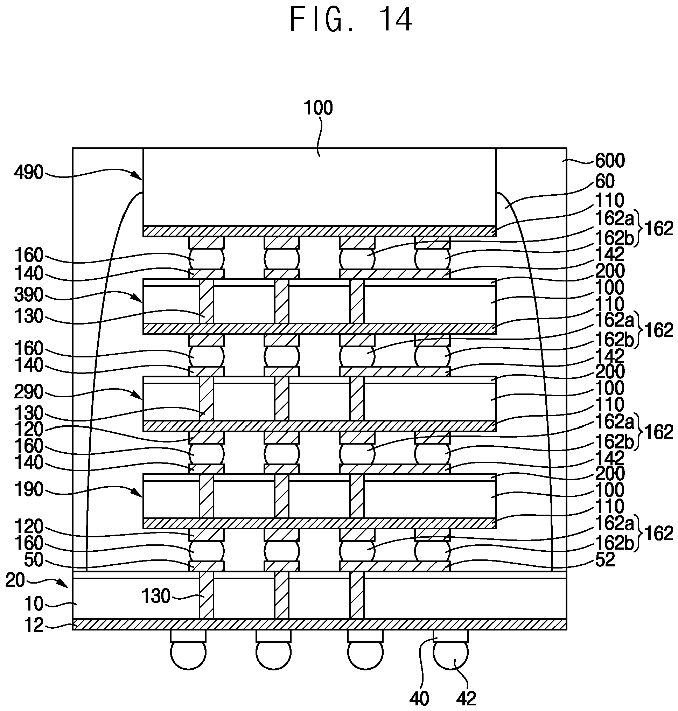

Referring to FIG. 14, the second semiconductor chip 290 may be attached on the first semiconductor chip 190. A third semiconductor chip 390 may be attached on the second semiconductor chip 290. In addition, a fourth semiconductor chip 570 may be attached on the third semiconductor chip 390. The attachment process of the semiconductor chip may be performed by the flip chip bonding process.

The adhesive material 60 may be formed between upper and lower adjacent semiconductor chips. In some example embodiments, the adhesive material 60 may be formed on sides of the semiconductor chips.

Thereafter, a sealing member 600 may be formed on the stacked structures including the buffer die 20 and the first to fourth semiconductor chips 190, 290, 390 and 490. In some example embodiments, the sealing member 600 may be formed on the adhesive material 60.

The base substrate 10 and the sealing member 600 may be cut to form a semiconductor package. The base substrate 10 and the sealing member 600 may be cut by a dicing process.

Horizontal thermal resistance and vertical thermal resistance of the semiconductor package may be decreased.

It will be understood that elements and/or properties thereof may be recited herein as being "the same" or "equal" as other elements, and it will be further understood that elements and/or properties thereof recited herein as being "identical" to, "the same" as, or "equal" to other elements may be "identical" to, "the same" as, or "equal" to or "substantially identical" to, "substantially the same" as or "substantially equal" to the other elements and/or properties thereof. Elements and/or properties thereof that are "substantially identical" to, "substantially the same" as or "substantially equal" to other elements and/or properties thereof will be understood to include elements and/or properties thereof that are identical to, the same as, or equal to the other elements and/or properties thereof within manufacturing tolerances and/or material tolerances. Elements and/or properties thereof that are identical or substantially identical to and/or the same or substantially the same as other elements and/or properties thereof may be structurally the same or substantially the same, functionally the same or substantially the same, and/or compositionally the same or substantially the same.

The foregoing is illustrative of some example embodiments and is not to be construed as limiting thereof. Although some example embodiments have been described, those skilled in the art will readily appreciate that many modifications are possible in the example embodiments without materially departing from the novel teachings and advantages of the inventive concepts. Accordingly, all such modifications are intended to be included within the scope of the inventive concepts. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the inventive concepts.

## Claims

1. A semiconductor package, comprising:
a first semiconductor chip including,
a circuit layer on a first surface of a first substrate,
first through silicon vias passing through the first substrate,
first lower bump pads on the circuit layer on the first substrate, each of the first lower bump pads connected to a corresponding one of the first through silicon vias, and
a first upper bump pad and a second upper bump pad on a second surface of the first substrate, the second surface opposite to the first surface of the first substrate, each of the first upper bump pad and the second upper bump pad connected to a corresponding one of the first through silicon vias;
a second semiconductor chip including,
a circuit layer on a first surface of a second substrate, and
second lower bump pads on the circuit layer on the second substrate;
a first solder bump between the first upper bump pad and the second lower bump pad to bond the first upper bump pad and the second lower bump pad; and
a plurality of second solder bumps between the second upper bump pad and the second lower bump pads to bond the second upper bump pad and the second lower bump pads,
wherein the plurality of second solder bumps are spaced apart from each other on the second upper bump pad.

2. The semiconductor package of claim 1, wherein an upper surface area of the second upper bump pad is greater than an upper surface area of the first upper bump pad.

3. The semiconductor package of claim 1, wherein
the second upper bump pad is shaped as a line in one direction to contact lower portions of the second solder bumps, and
the second solder bumps are spaced apart from each other in the one direction.

4. The semiconductor package of claim 1, wherein
an upper surface of the second upper bump pad has a rectangular shape to contact the second solder bumps,
at least some of the second solder bumps are spaced apart from each other in a first direction, and
at least some of the second solder bumps are spaced apart from each other in a second direction perpendicular to the first direction.

5. The semiconductor package of claim 1, wherein each of the first upper bump pad and the second upper bump pad includes at least one of copper, tin (Sn), nickel (Ni), gold (Au), or silver (Ag).

6. The semiconductor package of claim 1, wherein one of first solder bumps is bonded to one of the first upper bump pads.

7. The semiconductor package of claim 1, wherein the second solder bumps include signal transmission bumps and thermal path bumps.

8. The semiconductor package of claim 1, wherein
the second lower bump pads face the second upper bump pad in a vertical direction, and
one of the second lower bump pads faces one of the first through silicon vias.

9. The semiconductor package of claim 1, wherein
the second lower bump pads face the second upper bump pad in a vertical direction, and
some of the second lower bump pads do not face the first through silicon vias.

10. A semiconductor package, comprising:
a buffer die;
a plurality of first semiconductor chips sequentially stacked on the buffer die; and
a sealing member covering the first semiconductor chips on the buffer die,
wherein each of the first semiconductor chips includes,
a circuit layer on a first surface of a first substrate,
first through silicon vias passing through the first substrate,
lower bump pads on the circuit layer on the first substrate, each of the lower bump pads connected to a corresponding one of the first through silicon vias,
a first bump pad and a second bump pad on a second surface of the first substrate, the second surface opposite to the first surface of the first substrate, wherein an upper surface area of the second bump pad is greater than an upper surface area of the first bump pad,
a first solder bump between the first bump pad and one of the lower bump pads of one of the plurality of first semiconductor chips above the second surface, and
a plurality of second solder bumps between the second bump pad and lower bump pads of the one of the plurality of first semiconductor chips above the second surface.

11. The semiconductor package of claim 10, wherein the plurality of second solder bumps are spaced apart from each other on the second bump pad.

12. The semiconductor package of claim 10, wherein
the second solder bumps include a signal transmission bump and a thermal path bump,
the signal transmission bump faces one of the first through silicon vias of one of the plurality of first semiconductor chips below the signal transmission bump in a vertical direction, and
the thermal path bump does not face one of the first through silicon vias of the one of the plurality of first semiconductor chips below the thermal path bump in the vertical direction.

13. The semiconductor package of claim 10, wherein the first bump pad of a first one of the plurality of first semiconductor chips is aligned with the lower bump pad of a second one of the plurality of first semiconductor chips above the first one of the plurality of first semiconductor chips in a vertical direction.

14. The semiconductor package of claim 10, wherein the second bump pad of a first one of the plurality of first semiconductor chips faces a plurality of lower bump pads of a second one of the plurality of first semiconductor chips above the first one of the plurality of first semiconductor chips in a vertical direction.

15. The semiconductor package of claim 10, wherein each of the first solder bumps and the second solder bumps are matched 1:1 with one lower bump pad.
